# EUROPEAN PATENT APPLICATION

(11) **EP 1 091 625 A2**
(43) Date of publication of application: **11.04.2001**
(21) Application number: 00121296.8
(22) Date of filing: 06.10.2000
(51) Int. Cl.: H05K 1/05, H05K 1/02

(54) **Printed circuit with high heat dissipation capacity**

(30) Priority: 08.10.1999 IT MI992112
(71) Applicant: Auxilium S.r.l., 24060 Villongo (Bergamo) (IT)
(72) Inventor: Berta, Pier Battista, 24044 Daline, (Prov. of Bergamo) (IT)
(74) Representative: Modiano, Guido, Dr.-Ing.

(57) **Abstract**

A printed circuit (1) with high heat dissipation, comprising a base element (2) which is provided with at least one folding line (4) for forming an open box-like structure which is adapted to constitute a supporting element for the printed circuit.

## Description

The present invention relates to a printed circuit with high heat dissipation capacity.

It is known that printed circuits are used increasingly in the most disparate commercial products, since electronics has spread practically over every possible field of technology.

Printed circuits must have excellent heat dissipation, electrical insulation and the ability to withstand high amperages together with high frequencies.

These characteristics are achieved by using a particular type of material on which layers of copper are then applied which allow to form the paths of the printed circuit.

However, in order to provide heat dissipation, the printed circuit must be glued onto a supporting structure and then onto the heat sink. The supporting structure that constitutes the chassis of the printed circuit is a component which adds cost to the printed circuit and in any case requires a further step in order to be assembled with the printed circuit.

The aim of the present invention is to provide a printed circuit which has excellent heat dissipation and does not require a dedicated chassis.

Within the scope of this aim, an object of the present invention is to provide a printed circuit made of a material which allows excellent heat dissipation, electrical insulation and ability to withstand high amperages and frequencies.

Another object of the present invention is to provide a printed circuit which can be used in the most disparate devices with reduced costs and simplified operation.

Another object of the present invention is to provide a printed circuit which is highly reliable, relatively simple to manufacture and at competitive costs.

This aim and these and other objects which will become better apparent hereinafter are achieved by a printed circuit with high heat dissipation, characterized in that it comprises a base element provided with at least one folding line for forming an open box-like structure which is adapted to constitute a supporting element for said printed circuit.

Further characteristics and advantages of the present invention will become better apparent from the following detailed description of preferred but not exclusive embodiments of the printed circuit according to the invention, illustrated only by way of non-limitative example in the accompanying drawings, wherein:
Figure 1 is a plan view of the printed circuit according to the invention in an initial configuration;
Figure 2 is a perspective view of the printed circuit according to the invention in the final configuration for installation; and
Figures 3a-3c are sectional views of the printed circuit according to the present invention, according to different embodiments.

With reference to the above-cited figures, the printed circuit according to the invention, generally designated by the reference numeral 1, comprises a base element 2 which is made for example of aluminum and manganese alloy and on which electrical paths 3 are formed, as described in detail hereinafter.

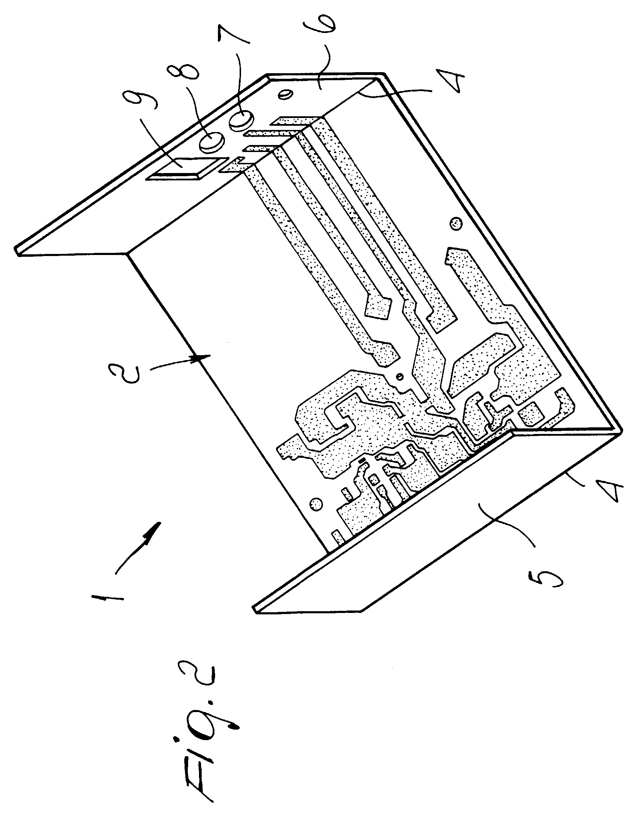

The particularity of the invention resides in that the base element made of aluminum and manganese alloy has one or more folding lines 4 which allow to fold the lateral edges of the base element 2, so as to provide a structure as shown in Figure 2, in which the printed circuit becomes the chassis and can therefore be installed directly in the apparatus, without having to provide an appropriate supporting element onto which the printed circuit is to be glued subsequently.

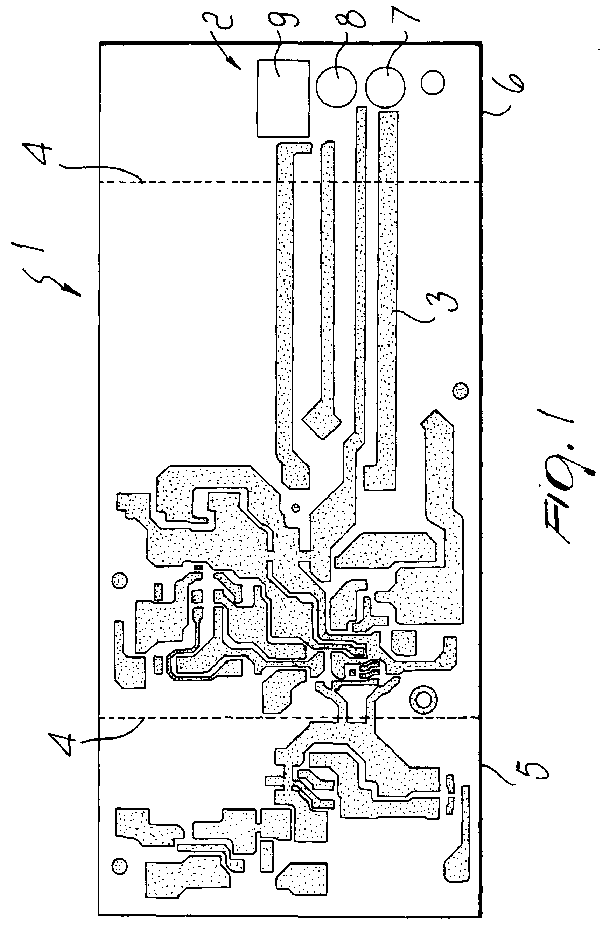

In practice, the folding at right angles of the edges, designated by the reference numerals 5 and 6 in Figure 1 by way of example, allows to form a sort of open box-like structure which directly constitutes the chassis of the printed circuit which is then installed in the apparatus for which it is provided, without additional costs for dedicated supporting elements.

The particularity of the invention also resides in that a layer of insulating and flexible polyester-based powder 10 is applied over the base element 2 and a copper lamina 11 of the chosen thickness is then applied thereon.

The layer of powder must have an elastic coefficient which is preferably better than that of the base element 2 and of the copper lamina arranged over it.

In detail, the method for manufacturing the printed circuit according to the invention provides for the following steps.

Initially, the layer of aluminum and manganese alloy 2 is subjected to a degreasing and alkaline pickling step followed by washing and is then subjected to steps for acid neutralization, chromate treatment, further washing, passivation, further washing and drying.

At this point the layer of powder 10, preferably a powder with a polyester binding agent with a thickness of 40 to 60 microns, is applied by means of an electrostatic system.

The base element 2 with the powder arranged on it is then subjected to annealing with a temperature which can vary from 140°C to 220°C; preferably 180°.

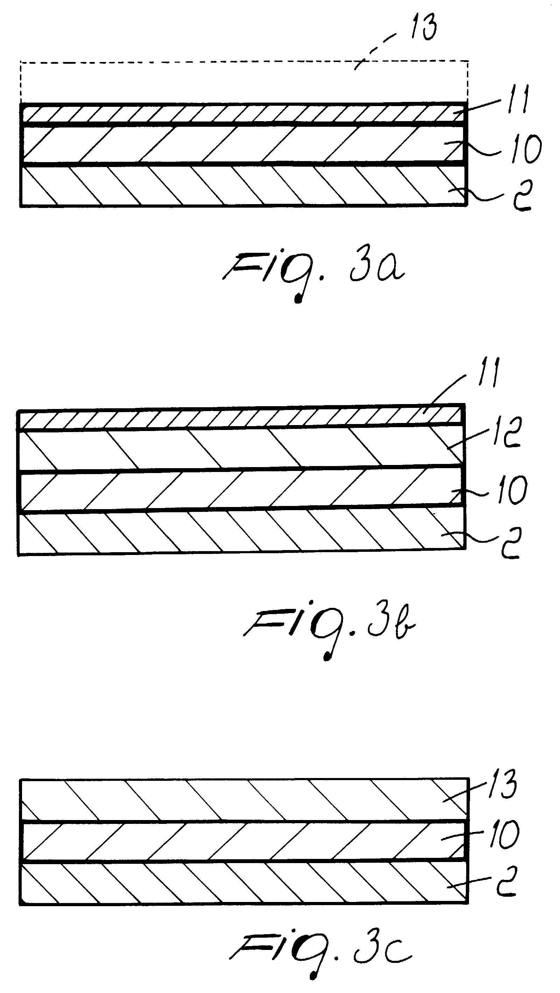

At this point, the printed circuit is subjected to satin finishing, washing, drying, optional deposition (see Figure 3b) of a layer of insulating dielectric 12, annealing, coupling with pre-preg, and final deposition of the copper lamina 11 (of a chosen thickness) with a final pressing step.

At this point, the steps that follow are the ordinary steps to which a conventional printed circuit is subjected.

As an alternative, instead of the copper lamina it is possible to print thick films 13 of conducting or resistive paste in a plurality of layers, with a step for annealing in a hot air oven, deposition of solder and final annealing at 170°C.

Also as an alternative, the thick-film pastes 13 can be deposited over the copper lamina 11 as well as instead of it.

The curvature of the base element 2 is in no way altered by the deposition of said thick-film pastes, which merely need to be dried and are such as to not undergo any alteration.

This allows to perform final polymerization as normally occurs in ordinary printed circuits.

As an alternative, it is possible to use a copper lamina which is already treated with adhesive for application on the layer of powder with a polyester binding agent.

It is important that the layer of powder 10 that is deposited on the base element 2 made of aluminum and manganese alloy has an elastic coefficient which allows folding of the base element 2, folding its edges so as to form a support for the printed circuit which is intrinsically provided in the chassis.

The folding of the edges 5 and 6 as shown in the figures allows to define passage regions for the electrical wires, designated by the reference numerals 7, 8 and 9 by way of example, which thus allow to connect the printed circuit 1 to an apparatus by means of pins.

The printed circuit thus conceived allows to have excellent heat dissipation, electrical insulation and ability to withstand high amperages and frequencies.

Moreover, the characteristic of being made of an alloy of aluminum and manganese allows to obtain a printed circuit which can be used directly as a chassis.

The printed circuit thus conceived is susceptible of numerous modifications and variations, all of which are within the scope of the inventive concept; all the details may furthermore be replaced with other technically equivalent elements.

In practice, the materials used, so long as they are compatible with the specific use, as well as the dimensions, may be any according to requirements and to the state of the art.

The disclosures in Italian Patent Application No. MI99A002112 from which this application claims priority are incorporated herein by reference.

Where technical features mentioned in any claim are followed by reference signs, those reference signs have been included for the sole purpose of increasing the intelligibility of the claims and accordingly, such reference signs do not have any limiting effect on the interpretation of each element identified by way of example by such reference signs.

## Claims

1. A printed circuit (1) with high heat dissipation, characterized in that it comprises a base element (2) which is provided with at least one folding line (4) for forming an open box-like structure which is adapted to directly constitute a supporting element for said printed circuit.

2. The printed circuit according to claim 1, characterized in that said base element (2) is made of an aluminum and manganese alloy.

3. The printed circuit according to claim 1, characterized in that it comprises two folding lines (4) which allow to form two edges (5,6) which are arranged at a 90° angle with respect to a region of said base element (2) defined between said folding lines.

4. The printed circuit according to claim 1, characterized in that said at least one folding line (4) forms a region which allows the connection of pins and the like for supplying said printed circuit (1).

5. The printed circuit according to claim 3, characterized in that it comprises, on said base element (2), a layer of powder (10) whose elastic coefficient allows to fold said edges (5,6) of said base element (2).

6. The printed circuit according to claim 5, characterized in that it comprises a copper lamina (11) on said layer of powder (10).

7. The printed circuit according to claim 5, characterized in that it comprises thick-film pastes (13) on said layer of powder (10).

8. The printed circuit according to claim 6, characterized in that it comprises a layer of thick-film pastes (13) on said copper lamina (11).

9. The printed circuit according to claim 5, characterized in that said layer of powder is a layer of powder (10) with a polyester binding agent, deposited with a thickness of 40 to 60 microns, said layer of powder having an elastic coefficient which is better than the elastic coefficient of said base element (2) and of said copper lamina (11).

10. The printed circuit according to claim 7, characterized in that said thick-film pastes (13) are multilayer conducting or resistive pastes.

11. A method for manufacturing a printed circuit, comprising a base element (2) which is made of aluminum and manganese alloy and has at least one folding line (4) for folding edges of said base element and forming a chassis which is integrated with said printed circuit, characterized in that it comprises the steps of:
subjecting said base element (2) made of aluminum and manganese alloy to an initial preparation step;
applying a layer of powder (10) with polyester binding agent onto said base element (2);
performing a step for annealing said base element (2) on which said layer of powder (10) has been deposited; and
applying a copper lamina (11) onto said layer of powder (10).

12. The method according to claim 11, characterized in that the step for the initial preparation of said base element (2) consists in subjecting said base element (2) to the steps of:
degreasing and pickling said base element (2) in an alkaline solution;
washing said base element (2);
neutralizing said base element (2) by means of acid;
subjecting said base element (2) to a chromate treatment;
washing said base element (2);
passivating said base element (2);
washing said base element (2) and drying it.

13. The method according to claim 11, characterized in that said step for annealing said base element (2) to which said layer of powder (20) is applied is performed at a temperature between 140 and 220°C.

14. The method according to claim 13, characterized in that said annealing step is performed at a temperature of 180°C.

15. The method according to claim 12, characterized in that it further comprises, after said annealing step, a step of subjecting said base element (2) to:
satin finishing:
washing;
drying.

16. The method according to claim 11, characterized in that it further comprises a step of depositing on said layer of powder (10) a layer of insulation dielectric (12) and of subjecting said dielectric layer to annealing.

17. The method according to claim 15, characterized in that it comprises a step of coupling with pre-preg before the deposition of said copper lamina (11).
